# EUROPÄISCHE PATENTSCHRIFT

(11) **EP 0 847 622 B1**
(45) Veröffentlichungstag und Bekanntmachung des Hinweises auf die Patenterteilung: **18.09.2002**
(21) Anmeldenummer: 97929119.2
(22) Anmeldetag: 19.06.1997
(51) Int. Cl.: H03J 1/00

(54) **VERFAHREN ZUR SPEICHERUNG DER DATEN EINER EMPFANGENEN TRÄGERFREQUENZ EINES RUNDFUNKSENDERS**
PROCESS FOR STORING OF DATA OF A RECEIVED CARRIER FREQUENCY OF A BROADCAST TRANSMITTER
PROCEDE DE MEMORISATION DE DONNEES D'UNE FREQUENCE PORTEUSE RECUE D'UN EMETTEUR DE RADIODIFFUSION

(30) Priorität: 29.06.1996 DE 19626253
(43) Veröffentlichungstag der Anmeldung: 17.06.1998
(73) Patentinhaber: ROBERT BOSCH GMBH, 70442 Stuttgart (DE)
(72) Erfinder: HEGELER, Wilhelm, D-31134 Hildesheim (DE)
(86) Internationale Anmeldenummer: DE9701263
(87) Internationale Veröffentlichungsnummer: WO98000915

(56) Entgegenhaltungen:
- EP-A- 0 429 000
- EP-A- 0 479 613
- GB-A- 2 240 677

## Beschreibung

### Stand der Technik

Es sind Rundfunkempfänger mit einem Datenspeicher auf dem Markt, in welchem die empfangenen Sender mit ihren PI-Codes und ihren alternativen Frequenzen in der Reihenfolge ihres Empfangs gespeichert werden.

Aus der EP-A-429000 (RDS-Rundfunkempfängen mit einen Einrichtung zur Länderspezifischen Auswertung von RDS-Daten) ist die Auswertung des "Land" Teils des PI-codes bekannt.

Aus der DE 3 917 263 A1 sind darüber hinaus Datenspeicher bekannt, in denen jeder Speicherzelle für eine alternative Frequenz ein deren Empfangshäufigkeit registrierender Bewertungsspeicher zugeordnet ist.

### Vorteil der Erfindung

Bei einer Änderung des empfangenen Programms wird in den bekannten Rundfunkempfängern zunächst geprüft, ob der dem neu eingestellten Programm zugeordnete PI-Code und die empfangene Trägerfrequenz bereits gespeichert sind. Bei dem erfindungsgemäßen Verfahren ist der Zeitbedarf für dieses Aufsuchen einer Trägerfrequenz im Datenspeicher gegenüber dem Stand der Technik verringert, was unter anderem dann von Gewicht ist, wenn im Ergebnis nur die Zahl in dem Bewertungsspeicher erhöht wird, weil die Trägerfrequenz bereits gespeichert ist.

### Zeichnung

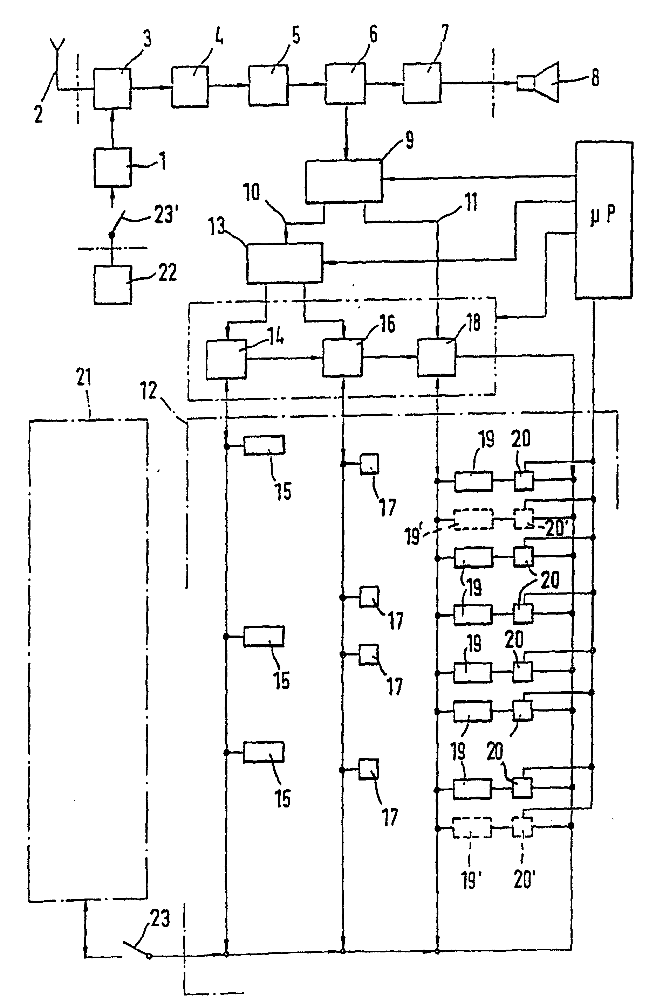

In der Zeichnung ist in
- Figur 1: das Blockschaltbild eines Rundfunkempfängers mit einem für das erfindungsgemäße Verfahren ausgebildeten Datenspeicher
dargestellt.

### Beschreibung

Der Rundfunkempfänger nach Figur 1 ist mittels eines Bedienteils 1 auf eine bestimmte Trägerfrequenz eines Rundfunksenders eingestellt, welche in dem über die angeschlossene Antenne 2 empfangenen Frequenzspektrum liegt. In der Mischstufe 3 wird die eingestellte Trägerfrequenz von den übrigen Trägerfrequenzen in dem empfangenen Frequenzspektrum getrennt. Die Modulation der eingestellten Trägerfrequenz wird dabei auf eine Zwischenfrequenz umgesetzt und in der ZF-Stufe 4 verstärkt und sodann im Demodulator 5 von der Zwischenfrequenz getrennt. Die Modulation durchläuft danach eine Frequenzweiche 6. Das niederfrequente Programmsignal in der Modulation wird in einer NF-Stufe 7 verstärkt und über einen angeschlossenen Lautsprecher 8 zu Gehör gebracht.

In einem Decoder 9, der einem zweiten Ausgang der Frequenzweiche 6 nachgeschaltet ist, werden der 57-kHz-Hilfsträger für die RDS-Signale in der Modulation eines empfangenen RDS-Senders demoduliert und die wiedergewonnenen RDS-Signale decodiert.

Der Ablauf der für die Decodierung erforderlichen Verfahrensschritte in dem Decoder 9 sowie für die Speicherung der empfangenen RDS-Signale in den nachfolgend beschriebenen Schaltstufen werden durch das Programm eines nicht näher dargestellten Mikroprozessors µP in an sich bekannter Weise gesteuert.

In der Figur 1 sind die nachfolgend beschriebenen Funktionsstufen der Ütiersichtlichkeithalber als räumlich getrennte Schaltstufen dargestellt. Deren Funktionen können aber auch durch zeitlich aufeinanderfolgende Funktionsschritte in einer programmgesteuerten Schaltstufe realisiert sein.

Nach der Decodierung sind an einem Ausgang 10 des Decoders 9 die Daten des wiedergewonnenen PI-Codes des empfangenen RDS-Senders und an einem Ausgang 11 die Daten der eingestellten Trägerfrequenz abnehmbar. Diese Daten werden mit den in einem Arbeitsspeicher 12 gespeicherten Daten verglichen und gegebenenfalls neu gespeichert.

In der Figur 1 sind die Speicherzellen für die zu speichernden Daten der Übersichtlichkeithalber nach ihrer unterschiedlichen Bedeutung und Zugehörigkeit räumlich getrennt dargestellt und die Speicherzellen gleicher Bedeutung untereinander durch eine Busleitung verbunden. In der Praxis wird diese Zuordnung der Daten zueinander in bekannter Weise durch eine entsprechende Adressierung der Daten bei ihrer Speicherung erreicht.

Das Programm des Mikroprozessors ist gegenüber dem Stand der Technik bei der Speicherung neuer Daten nun zusätzlich derart ausgelegt, daß zunächst in einer Regionalstufe 13, die dem Ausgang 10 des Decoders 9 nachgeschaltet ist, die Regionalkennung aus dem vollen PI-Code abgetrennt wird. Diese Regionalkennung wird beim erstmaligen Empfang eines PI-Codes getrennt vom Hauptteil des PI-Codes gespeichert.

Sodann wird der verbleibende Hauptteil des empfangenen PI-Codes in einer ersten Vergleichsstufe 14 oder in einem ersten Vergleichsschritt mit den nacheinander aufgerufenen in zugeordneten Speicherzellen 15 des Arbeitsspeichers 12 nach aufsteigenden Werten geordneten Hauptteilen bereits empfangener PI-Codes verglichen. Sobald sich eine Übereinstimmung bei dem Vergleich ergibt, wird eine zweite Vergleichsstufe 16 oder ein zweiter Vergleichsschritt freigegeben, in dem die abgetrennte Regionalkennung in dem empfangenen PI-Code mit den nacheinander aufgerufenen in zugeordneten Speicherzellen 17 hinter dem Hauptteil des PI-Codes nach aufsteigenden Werten geordnet gespeicherten Regionalkennungen früher empfangener Sender verglichen wird. Ergibt sich auch hier eine Übereinstimmung, dann wird eine dritte Vergleichsstufe 18 freigegeben, die im Ausgang 11 des Demodulators liegt, an dem, wie bereits erwähnt, die Daten der eingestellten Trägerfrequenz abnehmbar sind.

In der dritten Vergleichsstufe 18 oder in einem dritten Vergleichsschritt wird diese Frequenz mit den nacheinander aufgerufenen Frequenzen verglichen, die in Speicherzelle 19 eines der erkannten Region nachgeordneten Frequenzblocks gespeichert sind und dort bereits früher nach aufsteigenden Werten geordnet abgelegt wurden. Im Fall der Übereinstimmung steuert der Ausgang der dritten Vergleichsstufe 18 die Überprüfung der Zahl, die in einem Bewertungsspeicher 20 gespeichert ist, welcher der zum Vergleich abgefragten Speicherzellen 19 zugeordnet ist.

Die Bedeutung dieser Zahl ist von dem Programm des Mikroprozessors µP abhängig, sie kann z. B. eine Bewertung der Empfangswürdigkeit der Trägerfrequenz bei ihrem letztmaligen Empfang beinhalten, z. B. die Feldstärke. Ist diese neue Feldstärke größer als der gespeicherte Wert, dann wird dieser neue Wert in den Bewertungsspeicher eingeschrieben.

Findet sich keine übereinstimmende Frequenzangabe in den Speicherzellen 19, dann wird die neu eingestellte Trägerfrequenz in der ihr nach ihrer Größe zukommenden Stelle in eine leere Speicherzelle eingeschrieben. Ebenso wird die Regionalkennung bzw. der Hauptteil des PI-Codes der neu eingestellten Trägerfrequenz in eine leere Speicherzelle an der ihr zukommenden Stelle eingeschrieben. wenn sich bei einem der beiden zuvor erwähnten Vergleichsschritten keine Übereinstimmung ergibt.

Findet sich an der den Daten ihrer Größe nach zukommenden Stelle keine leere Speicherzelle, dann werden entweder
- die Daten, die größer als die empfangenen Daten sind und die vor der oder den nächsten leeren Speicherzellen liegen, zum Speicherende hin verschoben, so daß an der gewünschten Stelle eine oder mehrere leere Speicherzellen entstehen oder
- die Daten, die kleiner als die empfangenen Daten sind und hinter der nächsten leeren Speicherzelle liegen zum Speicheranfang hin verschoben, so daß an der gewünschten Stelle eine oder mehrere leere Speicherzellen entstehen.

Verfügt der Arbeitsspeicher 12 jedoch über keine leere Speicherzelle, dann erniedrigt das Programm des Mikroprozessors µP gleichzeitig alle in den Bewertungsspeichern 20 eingeschriebenen Zahlen um eine Einheit oder gegebenenfalls um mehrere Einheiten bis mindestens einer der Bewertungsspeicher 20 eine Null enthält, wodurch die zugehörige Frequenz gelöscht wird und mindestens eine leere Speicherzelle 19' entsteht, in die die verbleibenden Daten in der erwähnten Weise verschoben werden können.

Ist die zu löschende Frequenz die einzige Frequenz in dem einer Regionalkennung zugeordneten Frequenzblock, dann wird mit dieser Frequenz auch die Regionalkennung selbst und gegebenenfalls sogar der Hauptteil des PI-Codes gelöscht.

Die Abwertung des Inhalts des Bewertungsspeichers kann auch in regelmäßigen Abständen als Verfahrensschritt in das Programm des Mikroprozessors µP eingefügt sein, so daß eine zuvor gut empfangene Frequenz, die danach nicht wieder eingestellt wird, nach einer gewissen Zeit automatisch gelöscht ist und somit eine leere Speicherzelle erzeugt wird.

Nachdem alle erforderlichen Eintragungen bzw. Löschungen vorgenommen sind, werden die in dem Arbeitsspeicher 12 gespeicherten Angaben über einen Schalter 23 in einen identisch aufgebauten Dauerspeicher 21 übertragen. Erst wenn diese Übertragung abgeschlossen ist, darf die Stromversorgung 22 frühestens durch Öffnen des Folgeschalters 23' im Bedarfsfall vom Rundfunkempfänger wirksam getrennt werden.

Als Arbeitsspeicher 14 kann ein RAM zum Einsatz kommen, während für den Dauerspeicher 21 ein EEProm benutzt werden kann.

### Legende

- 1.: Bedienteil
- 2.: Antenne
- 3.: Mischstufe
- 4.: HF-Stufe
- 5.: Demodulator
- 6.: Frequenzweiche
- 7.: NF-Stufe
- 8.: Lautsprecher
- 9.: Decoder
- 10.: Decoderausgang 1
- 11.: Decoderausgang 2
- 12.: Arbeitsspeicher
- 13.: Regionalstufe
- 14.: Vergleichsstufe
- 15.: Speicherstellen P7
- 16.: Zweite Vergleichsstufe
- 17.: Speicherzahlen Regionalkennung
- 18.: dritte Vergleichsstufe
- 19.: Speicherzahlen Trägerfrequenz
- 19': Leere Speicherzelle
- 20.: Bewertungsspeicher
- 20': Leere Speicherzelle
- 21.: Dauerspeicher
- 22.: Stromversorgung
- 23.,23': Schalter

## Patentansprüche

1. Verfahren zur Speicherung der Daten einer empfangenen Trägerfrequenz eines Rundfunksenders und/oder der Bewertung ihres Empfangs in einem Datenspeicher eines Rundfunkempfängers,
**dadurch gekennzeichnet.**
**daß** aus der von der empfangenen Trägerfrequenz demodulierten vollen Senderkennung (PI-Code) die die Region kennzeichnende Regionalkennung abgetrennt wird, daß der verbleibende Hauptteil des PI-Codes mit den bereits im Datenspeicher (12) nach aufsteigenden Werten geordnet gespeicherten
PI-Codes-Hauptteilen (15) verglichen wird, bei erfolgreichem Vergleich, die Regionalkennung mit den bereits innerhalb des dem PI-Codes zugeordneten Datenblocks nach aufsteigenden Werten geordnet gespeicherten Regionalkennungen (17) verglichen wird, bei Erfolg dieses Vergleichs die Trägerfrequenz selbst mit den innerhalb des der Regionalkennung zugeordneten Frequenzblocks bereits nach aufsteigenden Werten geordnet gespeicherten Trägerfrequenzen (19) verglichen wird, und daß im Erfolgsfall des Vergleichs die Bewertung, in dem dieser Trägerfrequenz zugehörigen Bewertungsspeicher (20) geprüft und gegebenenfalls aufgewertet wird, daß ferner bei Fehlen eines Erfolges des Vergleiches die Trägerfrequenz bzw. die Regional kennung bzw. der Hauptteil des PI-Codes in einer leeren Speicherzelle, an der ihren Wert entsprechenden Platz gespeichert wird und daß bei Fehlen einer leeren Speicherzelle an diesem Platz die gespeicherten Daten mit höheren oder niedrigeren Werten gemeinsam in eine vorhandene leere Speicherzelle verschoben werden, und daß bei Fehlen einer leeren Speicherzelle im gesamten Speicher alle Bewertungsspeicher gleichzeitig abgewertet werden, bis mindestens eine leere Speicherzelle entsteht.

2. Verfahren nach Anspruch 1,
**dadurch gekennzeichnet,**
**daß** alle Bewertungsspeicher (20) in regelmäßigen Abständen zur zwischenzeitlichen Erzeugung leerer Speicherzellen gemeinsam abgewertet werden.

3. Verfahren nach Anspruch 1 oder 2,
**dadurch gekennzeichnet,**
**daß** der gesamte Inhalt des Datenspeichers (12) vor der Trennung von der Stromversorgung (22) in einen Dauerspeicher (21) eingelesen wird.

## Claims

1. Method for storing data at a received carrier frequency from a broadcast radio transmitter and/or for assessing its reception in a data memory of a broadcast radio receiver,
**characterized**
**in that** the region identification, which identifies the region, is separated from the complete transmitter identification (PI code), which is demodulated from the received carrier frequency, in that the remaining main part of the PI code is compared with the PI code main parts (15) which are already stored in the data memory (12) organized on the basis of rising values, if the comparison is successful, the regional identification is compared with the regional identifications (17) which are already stored organized on the basis of rising values within the data block associated with the PI code, if this comparison is successful, the carrier frequency is itself compared with the carrier frequencies (19) which have already been stored, organized on the basis of rising values, within the frequency block which is associated with the regional identification, and in that, if the comparison is successful, the assessment in the assessment memory (20) which is associated with this carrier frequency is checked, and, if necessary, reassessed, in that, furthermore, if the comparison is unsuccessful, the carrier frequency or the regional identification or the main part of the PI code is stored in an empty memory cell, at the location corresponding to its value, and in that, if there is no empty memory cell at this location, the stored data with higher or lower values is shifted jointly to an available empty memory cell, and in that if there is no empty memory cell in the entire memory, all the assessment memories are devalued simultaneously, until at least one empty memory cell occurs.

2. Method according to Claim 1,
**characterized**
**in that** all the assessment memories (20) are devalued jointly at regular intervals in order to produce empty memory cells in the meantime.

3. Method according to Claim 1 or 2,
**characterized**
**in that** the total contents of the data memory (12) are read to a non-volatile memory (21) before disconnection from the power supply (22).

## Revendications

1. Procédé d'enregistrement de données d'une fréquence porteuse d'un émetteur radio et/ou l'évaluation de sa réception dans une mémoire de données d'un récepteur radio,
**caractérisé en ce qu'**
à partir de la caractéristique d'émetteur, complète (Code PI) démodulée de la fréquence de porteuse reçue, on sépare la caractéristique régionale caractérisant la région,
on compare la partie principale restante du code PI avec les valeurs des parties principales de code (15) PI déjà enregistrées dans la mémoire de données (12) selon un ordre croissant, et en cas de comparaison réussie, on compare la caractéristique régionale aux caractéristiques régionales (17) déjà enregistrées, associées dans le bloc de données associé au code PI suivant un ordre croissant, et en cas de comparaison réussie, on compare la fréquence porteuse elle-même avec les fréquences porteuses (19) enregistrées dans l'ordre croissant à l'intérieur du bloc de fréquence associé à la caractéristique régionale, et
en cas de réussite de la comparaison, on vérifie l'évaluation dans la mémoire d'évaluation (20) correspondant à cette fréquence de porteuse et on l'exploite le cas échéant, en outre en l'absence de réussite de la comparaison on enregistre la fréquence porteuse ou la caractéristique régionale ou la partie principale du code PI, dans une cellule de mémoire vide à l'emplacement qui correspond à sa valeur, et
en l'absence de cellules de mémoire vides à cet endroit on décale ensemble les données enregistrées avec des valeurs supérieures ou inférieures, dans une cellule de mémoire vide existante, et
en l'absence d'une cellule de mémoire vide dans l'ensemble de la mémoire on traite simultanément toutes les mémoires d'évaluation jusqu'à obtenir au moins une cellule de mémoire vide.

2. Procédé selon la revendication 1,
**caractérisé en ce qu'**
on traite ensemble toutes les mémoires d'évaluation (20) à des intervalles réguliers pour créer dans l'intervalle de temps des cellules de mémoire vide.

3. Procédé selon l'une quelconque des revendications 1 ou 2,
**caractérisé en ce qu'**
on enregistre tout le contenu de la mémoire de données (12) avant de couper l'alimentation électrique (22) dans une mémoire permanente (21).
